# EUROPÄISCHE PATENTSCHRIFT

(11) **EP 0 840 415 B1**
(45) Veröffentlichungstag und Bekanntmachung des Hinweises auf die Patenterteilung: **29.08.2001**
(21) Anmeldenummer: 97117730.8
(22) Anmeldetag: 14.10.1997
(51) Int. Cl.: H02B 13/065, G01R 31/12

(54) **Verfahren zur Erfassung eines Störlichtbogens und Lichtbogenwächter hierfür**
Method for detecting fault arcs and arc monitoring device therefor
Méthode pour détecter les arcs de défauts et appareil de surveillance associé

(30) Priorität: 02.11.1996 DE 19645158
(43) Veröffentlichungstag der Anmeldung: 06.05.1998
(73) Patentinhaber: AEG Sachsenwerk GmbH, D-93055 Regensburg (DE)
(72) Erfinder: Jakob, Karl, Dipl.-Phys., 93049 Regensburg (DE)
(74) Vertreter: Dreiss, Fuhlendorf, Steimle & Becker

(56) Entgegenhaltungen:
- EP-A- 0 249 815
- DE-A- 3 141 374
- DE-A- 19 534 403

## Beschreibung

Die Erfindung betrifft ein Verfahren zur Erfassung eines Störlichtbogens in einer elektrischen Einrichtung sowie einen Lichtbogenwächter zur Ausübung dieses Verfahrens.

Ein bekannter Lichtbogenwächter (Elektrotechnische Zeitschrift, 1983 H. 18, S. 975-978) weist eine Lichtsensoreinheit auf, die ein teilweise digital arbeitendes Auswertegerät derart steuert, daß beim Auftreten von Lichtbögen in einer entsprechenden elektrischen Einrichtung eine Abschaltung des überwachten gestörten Anlagenteils angeregt wird. Das Auswertegerät bewertet die Dauer des linearisierten Lichtanstiegs bei sinusförmigem Lichtbogenstrom innerhalb eines vorgegebenen Meßzeitraums von ca. 3 Millisekunden. Während dieses Meßzeitraums wird der Beleuchtungsstärke-Anstieg ermittelt und mit einem vorbestimmten Grenzwert verglichen. Bei einem Beleuchtungsstärke-Anstieg, wie er für Störlichtbögen typisch ist, spricht der Lichtbogenwächter an und erzeugt ein Auslösesignal, das eine Schalteinrichtung zur Abschaltung des mit dem Störlichtbogen behafteten elektrischen Geräteteils steuert. Von Nachteil ist hierbei, daß Photoblitze, aber auch übliche energiereiche Schaltlicht-bögen beim ordnungsgemäßen Schalten der elektrischen Stromkreise des Geräts zur Anregung der Schalteinrichtung führen kann, welche den auf Störlichtbögen zu überwachenden Stromkreis unterbricht. Durch Dokument DE-A- 3 141 374 ist eine weitere Anordnung zur Überwachung von elektrischen Einrichtungen bekannt.

Der Erfindung liegt die Aufgabe zugrunde, ein gattungsgemäßes Verfahren und einen Lichtbogenwächter zur Ausübung dieses Verfahrens anzugeben, die bei hoher Ansprechempfindlichkeit eine zuverlässige Erkennung von Störlichtbögen ermöglichen.

Die Lösung dieser Aufgabe erfolgt gemäß der Erfindung durch die kennzeichnenden Merkmale der Ansprüche 1 und 10. Vorteilhafte Ausgestaltungen sind den weiteren Ansprüchen zu entnehmen.

Bei einer Verfahrensweise gemäß der Erfindung wird bei einer signifikanten Änderung der Beleuchtungsstärke in dem zu überwachenden Gerät lediglich der Anstieg der Beleuchtungsstärke in der Weise ausgewertet, daß daraus aus Integration über einen ersten Teilmeßzeitraum in mehreren Schritten ein jeweils augenblicklich aktueller relativer Belichtungsistwert ermittelt wird. Dieser in zeitabhängigen Schritten ermittelte Belichtungs-Istwert wird jeweils mit einem während des ersten Teilmeßzeitraums konstanten ersten Belichtungsgrenzwert verglichen. Dieser erste Belichtungsgrenzwert ist so gewählt, daß dann, wenn der Belichtungs-Istwert am Ende des ersten Teilmeßzeitraumes diesen Grenzwert nicht erreicht hat, der Energieinhalt des delektierten Lichtereignisses so klein ist, daß ein Störlichtbogen in keinem Fall vorliegen kann. Photoblitze, das Bestrahlen des optischen Sensors mit einer leistungsstarken Arbeitsleuchte und dgl. werden dadurch als Auslöser für eine Abschaltung der Energiezufuhr im überwachten Gerät eliminiert. Übersteigt der jeweilige Beleuchtungs-Istwert während des ersten Teilmeßzeitraums den ersten Beleuchtungsgrenzwert, dann ist zwar davon auszugehen, daß ein energiereicher Lichtbogen aufgetreten ist, der jedoch auch von einem Schaltfunken eines im Gerät enthaltenen Schalters herrühren kann. Bei fortgesetzter zeitabhängiger Integration des aktuellen Beleuchtungsstärkewertes wird dann über den aus dem erfaßten aktuellen Lichtereignis gewonnenen Belichtungs-Istwert eine Überprüfung des Lichtbogen-Energieinhalts dadurch vorgenommen, daß der jeweilige Belichtungs-Istwert während des fortlaufenden, aber begrenzten Meßzeitraums wieder in mehreren Zeitschritten mit einem zweiten Belichtungsgrenzwert verglichen wird, der oberhalb des ersten Grenzwerts liegt. Der gesamte Meßzeitraum kann dabei beispielsweise 250 Millisekunden betragen. Wird während dieses gesamten Meßzeitraums der zweite Belichtungsgrenzwert nicht überschritten, ist der Energieinhalt des Lichtbogens so gering, daß eine Gefährdung des überwachten Geräts nicht gegeben ist und der aktuelle Lichtbogen auf einen üblichen Schaltvorgang eines Schalters zurückzuführen ist. Der zweite Belichtungsgrenzwert wird dementsprechend hoch vorgegeben.

Wenn dagegen zu irgendeinem Zeitpunkt innerhalb des mit dem Auftreten des Lichtereignisses gestarteten Integrationsvorganges der zweite Belichtungsgrenzwert überschritten wird, erfolgt eine sofortige Anregung zur Abschaltung des gestörten Stromkreises. Dabei kann die Abschaltung unmittelbar erfolgen, sie kann jedoch auch abhängig davon ausgeführt werden, ob ein dem zu überwachenden Stromkreis zugeordneter stromabhängiger Auslöser einen überhöhten Stromwert signalisiert. Bei dieser Kombination von Ausschaltkriterien wird berücksichtigt, daß ein Störlichtbogen zwischen Phasenleitern oder einem Phasenleiter und Masse immer mit einem überhöhten Stromfluß verkoppelt ist.

Ist eine Änderung der Beleuchtungsstärke aufgetreten, die den Integrationsvorgang gestartet hat, ohne zu einer Abschaltung der überwachten elektrischen Einrichtung geführt zu haben, dann kann dieses Ereignis z.B. dadurch eingetreten sein, daß zusätzlich zu einer Allgemeinbeleuchtung ein leistungsstarker Arbeitsstrahler eingeschaltet wurde. Um derartige Änderungen aus dem Meßergebnis zu eliminieren, wird der vor einem die Beleuchtungsstärke signifikant ändernden Lichtereignis vorhandene Beleuchtungsstärkewert in einen Beleuchtungsstärkeschwellwert umgesetzt und gespeichert. Nach der Feststellung, daß dieses Lichtereignis im Vergleich zu einem Störlichtbogen unbedeutend war, wird der Belichtungsgrenzwert erhöht, so daß der erhöhte Gleichlichtpegel bei der Auswertung eines nachfolgenden Lichtereignisses im Integrationsprozeß berücksichtigt wird. Eine Anhebung des Belichtungsgrenzwertes ist auch dann zweckmäßig wenn ein üblicher Schaltlichtbogen aufgetreten ist. Dann ist es jedoch auch zweckmäßig, bei erhöhtem Beleuchtungsstärkegrenzwert den ersten Belichtungsgrenzwert ebenfalls anzuheben.

Wenn im übrigen während des ersten Teilmeßzeitraums keine Überschreitung des ersten Belichtungsgrenzwertes eintritt, kann unmittelbar anschließend nicht nur der Beleuchtungsstärkeschwellwert angepaßt sondern auch der Integrationsvorgang abgebrochen und der aktuelle Belichtungs-Istwert gelöscht werden. Dadurch kann noch vor Ende des gesamten Meßzeitraums ein neu eintretendes relevantes Lichtereignis ausgewertet werden.

Die Erfindung ist nachfolgend anhand von Prinzipskizzen eines Ausführungsbeispiels näher erläutert.

Es zeigen:
- FIG. 1: ein elektrisches Mittelspannungsschaltfeld mit einem zugeordneten Lichtbogenwächter und
- FIG. 2: ein Kennlinienfeld für unterschiedliche Lichtereignisse.

Ein Schaltfeld 1 einer Mittelspannungsschaltanlage weist unterschiedliche Schotträume 2 auf, in welchen einerseits Sammelschienen 3 und Schaltkontaktstrecken 4 und andererseits zumindest ein den Energiefluß zwischen den Sammelschienen 3 und einem Kabelabgang 5 beherrschender Leistungs- oder Lasttrennschalter 6 und weitere Schaltkontaktstrecken 7 angeordnet sind. Aus den Schotträumen 2 führen jeweils Lichtwellenleiter 8 zu einem Auswertegerät 15, das Eingänge für Überstrom- und Schalter-Signale 9, 10 sowie einen Ausgang 11 für ein Auslösesignal zumindest für den Schalter 6, einen Ausgang 12 für die Verbindung mit einer Störmeldeeinrichtung, einen Ausgang 13 zu einer Melde- /oder Anzeigeeinrichtung für ein Störlichtbogenereignis aufweist. Ein bidirektionaler Ein-/Ausgang 16 dient zur Kopplung mit anderen Schaltfeldern oder Geräten, um einen Datenaustausch vornehmen zu können.

Die Lichtwellenleiter 8 sind Teil eines optoelektronischen Meßwertwandlers, der über einen optischen Sensor über die Lichtwellenleiter 8 Lichtbogenereignisse in den Schotträumen 2 detektiert. Der Meßwertwandler setzt diese Lichtsignale fortlaufend in entsprechende elektrische Beleuchtungsstärkewerte um, die dem Absolutwert der in den Schotträumen herrschenden Beleuchtungsstärke entsprechen. Der Meßwertwandler 14 ist dabei in ein Auswertegerät 15 integriert, in dem die im Meßwertwandler 14 umgesetzten Beleuchtungsstärkewerte ausgewertet werden. Das Auswertegerät 15 umfaßt dabei einen Beleuchtungsstärkeschwellwertspeicher, in dem ein Beleuchtungsstärkeschwellwert abgelegt wird, der sich aus der Beleuchtungsstärke ableitet, welche in den Schotträumen 2 infolge Tageslicht, Anlagebeleuchtung oder dgl. gegeben ist. Derartige Beleuchtungswerte unterliegen in der Regel keinen beachtlich schnellen Änderungen.

Unabhängig davon wird der über die Lichtwellenleiter 8 ermittelte augenblickliche Beleuchtungsstärkewert fortlaufend mit dem Beleuchtungsstärkeschwellwert verglichen. Tritt dabei ein Lichtereignis ein, das den aktuellen Beleuchtungsstärkewert beachtlich ansteigen läßt, wird durch einen Vergleich zwischen aktuellem Beleuchtungsstärkewert und gespeichertem Beleuchtungsstärkeschwellwert der Zeitpunkt des Beginns der Änderung festgestellt und daraus ein Startsignal für einen im Auswertegerät 15 enthaltenen Integrator generiert. Der Integrator integriert den Differenzwert aus aktuellem Beleuchtungsstärkewert und dem abgespeicherten Beleuchtungsstärke-Sollwert und bildet daraus einen sich aus der Dauer und Intensität des zusätzlich aufgetretenen Lichtereignisses daergebenden zeitabhängigen Belichtungs-Istwert. Der Belichtungs-Istwert stellt dabei eine Abbildung für den Energieinhalt des die Beleuchtungsstärkeänderung hervorrufenden Lichtereignisses dar.

Um Aufschluß über den Energieinhalt des Lichtbogenereignisses zu gewinnen, wird der jeweils zeitabhängig ermittelte Belichtungs-Istwert einem Vergleicher zugeführt, der diesen Belichtungs-Istwert fortlaufend mit einem ersten vorgegebenen Beleuchtungsgrenzwert vergleicht. Dieser erste Beleuchtungsgrenzwert ist so gewählt, daß beispielsweise ein durch Zuschalten einer Halogenarbeitsleuchte erzeugtes Lichtsignal zwar den Integrationsvorgang auslöst, jedoch innerhalb eines ersten Teilmeßzeitraums, der vorzugsweise 5 Millisekunden beträgt, den Belichtungs-Istwert nicht bis zum Belichtungsgrenzwert ansteigen läßt. Tritt dagegen ein intensiver Schaltlichtbogen am Schalter 6 oder an den Schaltkontaktstrecken 4 auf, dann kann der aktuelle Belichtungs-Istwert während des ersten Teilmeßzeitraumes den ersten Belichtungsgrenzwert überschreiten. Dieser Fall tritt natürlich auch dann auf, wenn ein Störlichtbogen zwischen den Sammelschienenleitern 3 oder gegen die geerdete Wandung 17 auftritt. In beiden Fällen ist die Anstiegssteilheit der im Lichtbogen umgesetzten Energie zu Beginn des Lichtbogenereignisses so groß, daß die Gefahr einer Beschädigung von Anlageteilen besteht. Aus diesem Grunde wird in diesem Falle die Integration des aktuellen Beleuchtungsstärkewertes während des vorgegebenen Meßzeitraums, der 250 Millisekunden betragen kann, fortgeführt. Der sich daraus ergebende zeitabhängige Belichtungs-Istwert wird zur Unterscheidung eines Schaltlichtbogens von einem Störlichtbogen weiterhin fortlaufend mit einem zweiten Belichtungsgrenzwert verglichen, der wesentlich höher als der erste Belichtungsgrenzwert bemessen ist. Führt dabei die weitere zeitabhängige Integration des in den Schotträumen 2 herrschenden Beleuchtungsstärkewertes nicht zum Überschreiten des zweiten Belichtungsgrenzwertes, dann ist der Energieinhalt des detektierten Lichtereignisses so gering, daß eine Beschädigung von Schaltfeldteilen nicht zu erwarten ist, es sich also um einen betriebsüblichen Schaltlichtbogen handelt.

Wenn dagegen der aktuelle Beleuchtungs-Istwert auch den zweiten Beleuchtungsgrenzwert innerhalb des vorgegebenen gesamten Meßzeitraums überschreitet, gibt die betreffende Vergleichseinrichtung ein Absteuersignal ab, das die Abschaltung des Schalters 6 oder übergeordnete Schalteinrichtungen über den Schaltausgang 11 zumindest anregt oder gar die Abschaltung bewirkt. In diesem Falle wird auch über den Ausgang 13 des Auswertegerätes 15 ein Signal an eine akustische oder optische Anzeigevorrichtung ausgegeben, die das Lichtbogenereignis dauerhaft bis zum manuellen Löschen dokumentiert. Sofern andere Geräte in einem solchen Störfalle Informationsmeldungen erhalten sollen, können diese über die Anschlüsse 16 des Auswertegeräts 15 ausgegeben werden. Über diesen Anschluß 14 können aber auch Meldungen anderer Geräte an das Auswertegerät 15 übertragen werden.

Um die Sicherheit gegen Falschabschaltungen zu erhöhen, kann der Ausgang des das Absteuersignal generierenden Vergleichers im Auswertegeräts 15 an einen Eingang einer logischen UND-Schaltung geschaltet werden, deren zweiter Eingang mit dem Eingang 9 des Steuergeräts verbunden ist, welcher seinerseits an den Ausgang eines Überstromsensors angeschaltet ist, der den elektrischen Strom im überwachten Schaltfeld 1 über einen Stromwandler und ein Überstromrelais erfaßt. Wenn dabei sowohl das Absteuersignal als auch das Überstromsignal anstehen, ist sicher, daß das Lichtereignis durch einen Störlichtbogen ausgelöst ist, weil nur beim Auftreten beider Ereignisse auch beide Signale vorhanden sind.

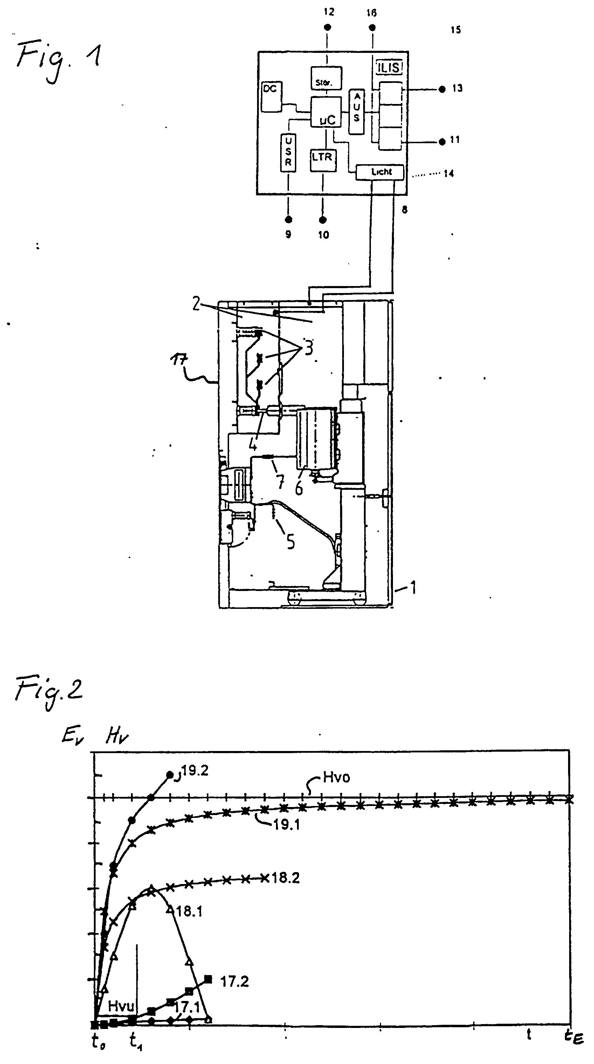

In FIG. 2 sind beispielhaft Kurvenverläufe für Beleuchtungsstärke Ev und zugehörige Belichtungswerte Hv über der Zeit aufgetragen. Es wird davon ausgegangen, daß im zu überwachenden elektrischen Gerät Tageslicht oder Licht aus der Anlagenbeleuchtung detektiert wird, wobei die daraus resultierenden Beleuchtungsstärkewerte im Vergleich zu Lichtbogenereignissen oder dgl. sehr gering sind. Um derartige unbedeutende Lichteinflüsse dennoch aus dem Meßergebnis zu eliminieren, wird ein Beleuchtungsstärkegrenzwert festgelegt, der oberhalb der erwähnten weitgehend statischen Beleuchtungstärkewerte liegt. Tritt ein Lichtereignis z.B. durch zusätzliches Einschalten eines Halogenstrahlers auf, weil z.B. eine optische Inspektion durch Schutzglasscheiben hindurch vorgenommen wird, dann ergibt sich ein relativ langsamer Anstieg der Beleuchtungsstärke auf einen niedrigen Maximalwert, wie er durch den Kurvenzug 17.1 angedeutet ist. Die Integration dieses Beleuchtungsstärkesignals über die Zeit ergibt einen exponentiellen Anstieg des zugehörigen Belichtungswertes mit geringer Anfangssteilheit, wie es die zugehörige Belichtungs-Istwertkurve 17.2 schematisch wiedergibt. Dabei erfolgt der Start der Integration dann, wenn der aktuelle Beleuchtungsstärkewert den vorbestimmten Beleuchtungsstärkeschwellwert Evd übersteigt.

Beim Auftreten eines Schaltlichtbogens kann beispielsweise ein Kurvenverlauf der Beleuchtungsstärke gemäß dem Kurvenzug 18.1 mit wesentlich steilerem Anstieg auf einen höheren Endwert eintreten. Bei der Integration dieses Kurvenverlaufs 18.1 über die Zeit ergibt sich dann beispielsweise ein Verlauf des Belichtungswertes entsprechend dem zugehörigen Kurvenzug 18.2.

Tritt schließlich ein Störlichtbogen auf, der aufgrund seiner hohen Energie einen sehr steilen Anstieg und einen sehr hohen Endwert der Beleuchtungsstärke entsprechend Kurve 19.1 aufweist, dann steigt der zugehörige Belichtungs-Istwert extrem steil auf sehr hohe Werte entsprechend dem Kurvenverlauf 19.2 an.

Um hieraus die notwendigen Schaltsignale gewinnen zu können, wird ein erster Belichtungsgrenzwert Hvu festgelegt, der zwischen dem Beginn des Lichtbogenereignisses beim Zeitpunkt t0 bis zum Ende eines ersten Teilmeßzeitraumes von beispielsweise 5 Millisekunden für die Auswertung relevant ist und bis zum Meßzeitpunkt t1 dauert. Während dieses ersten Teilmeßzeitraumes an t0 bis t1 werden die Belichtungs-Istwerte 17.2, 18.2, 19.2 im Takte der Integrationsschritte mit dem ersten Belichtungsgrenzwert Hvu in einer Vergleichseinrichtung verglichen. Bei einem sehr energieschwachen Beleuchtungsereignis gemäß Kurve 17.2 wird der Belichtungsgrenzwert Hvu während des ersten Teilmeßzeitraumes t0-t1 nicht erreicht. Dagegen überschreitet der Belichtungs-Istwert bei stärkeren und sehr starken sowie länger andauernden Lichtereignissen, wie sie sich bei Lichtbögen einstellen, innerhalb des ersten Teilmeßzeitraums t0-t1 dem ersten Belichtungsgrenzwert Hvu, wodurch der Integrationsprozeß über den ersten Teilmeßzeitraum hinweg bis maximal zum Ende des gesamten Meßzeitraumes ausgeführt wird.

Bei schwachen Lichtereignissen dagegen kann der Integrationsprozeß bereits am Ende des ersten Teilmeßzeitraums abgebrochen, der gespeicherte Belichtungs-Istwert gelöscht und der Beleuchtungsstärkeschwellwert erhöht werden, weil davon auszugehen ist, daß eine Zusatzbeleuchtung eingeschaltet wurde. Der Lichtbogenwächter ist dann für die Detektion eines neuen, den erhöhten Beleuchtungsstärkegrenzwert überschreitenden Lichtereignisses bereit. Eine die Abschaltung der Energieversorgung zum elektrischen Gerät anregende Steuerhandlung ist dadurch nicht angezeigt und es wird kein Absteuersignal generiert, das eine Schalteinrichtung zur Abschaltung der elektrischen Energie zur überwachten elektrischen Einrichtung anregt.

Nach der Feststellung eines Lichtereignisses mit hoher oder sehr hoher Beleuchtungsstärke und Überschreiten des ersten Belichtungsgrenzwertes innerhalb des ersten Teilmeßzeitraumes wird der dann jeweils durch Integration ermittelte Belichtungs-Istwert im Takt des Integrationszyklus mit dem zweiten, wesentlichen höheren Belichtungsgrenzwert verglichen, der so bemessen ist, daß bei seinem Erreichen bzw. Überschreiten ein Störlichtbogenereignis zugrunde liegen muß. Wenn demnach ein Lichtbogenereignis gemäß Kurve 18.2 festgestellt wird, erreicht der daraus abgeleitete Belichtungs-Istwert innerhalb des vorgegebenen gesamten Meßzeitraums am Endpunkt tE nicht den zweiten höheren Belichtungsgrenzwert Hvo. In diesem Falle generiert der Vergleicher, der den Belichtungs-Istwert im Meßzeitraum t0-tE mit dem zweiten Belichtungsgrenzwert Hvo vergleicht, bei Nichterreichen des zweiten Belichtungsgrenzwertes Hvo ein Signal, das wiederum lediglich eine Erhöhung des im Beleuchtungsstärke-Schwellwertspeichers abgelegten Beleuchtungsstärkeschwellwertes, eine Abschaltung des Integrators und die Löschung des aktuell integrierten Belichtungs-Istwertes in einem Belichtungsgrenzwertspeicher steuert. In analoger Weise läuft auch der Steuerungsvorgang im Falle der schwachen Beleuchtungserhöhung gemäß Kurve 17.2 ab.

Wenn dagegen der Belichtungs-Istwert aufgrund des extrem steilen Anstiegs und seiner Dauer gemäß Kurve 19.2 nicht auf ein Blitzlicht sondern auf ein energieintensives Störlichtbogenereignis zurückzuführen ist, dann überschreitet der Belichtungs-Istwert gegebenenfalls noch während des ersten Teilmeßzeitraums t1-t0 den zweiten Belichtungsgrenzwert Hvo. Die in diesem Falle aktivierte Vergleichseinrichtung generiert dann ein Absteuersignal, welches eine Schalteinrichtung zur Abschaltung des Energiezustroms zur überwachten elektrischen Einrichtung zumindest anregt oder ggf. auch unmittelbar steuert.

Um jedoch Fehlabschaltungen zu vermeiden, ist der Ausgang des das Absteuersignal generierenden Vergleichers an einen Eingang einer logischen UND-Schaltung geschaltet, deren zweiter Eingang an den Ausgang eines Überstromsensors angeschlossen ist. Erst wenn das aus dem energieintensiven Lichtbogenereignis abgeleitete Befehlssignal und das Überstromsignal vorliegen, wird demnach die Abschaltung unverzüglich gesteuert.

Wenn ein üblicher, beim Schalten beispielsweise eines Lasttrennschalters auftretendes Lichtbogenereignis gemäß Kurve 18.2 ermittelt wird, ist es zweckmäßig, den im Beleuchtungsstärkeschwellwertspeicher abgelegten Beleuchtungsstärkeschwellwert zu erhöhen.

Bei einer Erhöhung des Beleuchtungsstärkeschwellwertes im Beleuchtungsstärkeschwellwertspeicher wird dann eine angepaßte Erhöhung des ersten Belichtungsgrenzwertes in einem zugehörigen Belichtungsgrenzwertspeicher vorgenommen. Dadurch wird, ein Ansprechen der Abschalteinrichtung durch den Wechselanteil von Lichtquellen verhindert. Bei abnehmender Grundbeleuchtungsstärke wird dagegen die Detektionsschwelle nach einer Filterfunktion zu niederigen Werten hin angepaßt.

Eine Erhöhung der Sicherheit gegen Fehlabschaltungen wird noch dadurch erreicht, daß über einen Schließerkontakt eines Hilfsschalters am Lasttrennschalter oder einem anderen in einen zu schaltenden Stromweg geschalteten Schalter ein entsprechendes Schaltersignal auf den Eingang 10 des Auswertegerätes 15 aufgeschaltet wird. Dieser Schließerkontakt wird bei Ausschaltungen wenigstens 1 Millisekunde vor der Kontakttrennung der Hauptstrombahn oder bei Einschaltungen mehr als 5 Millisekunden vor Kontaktberührung für mindestens 1 Millisekunde geschlossen. Dieses Schaltersignal wird im Auswertegerät 15 für 250 Millisekunden gespeichert. Nach der Registrierung dieses Schaltersignals im Auswertegerät wird nach einem unmittelbar darauffolgenden Anstieg der Beleuchtungsstärke der Integrator zwar gestartet, jedoch wird dann zumindest am Ende dieses zweiten Teilmeßzeitraumes, der den ersten Teilmeßzeitraum einschließt, der durch Integration ermittelte Belichtungs-Istwert gelöscht. Der Integrationsprozeß wird jedoch fortgesetzt bis zum Abschluß des Meßzeitbereichs. Dadurch wird zwar der zu erwartende Schaltlichtbogen aus dem Meßergebnis eliminiert. Wenn jedoch aufgrund des Schaltvorganges oder aus anderen Gründen ein Störlichtbogen auftritt, wird derselbe unter Berücksichtigung des zweiten Belichtungsgrenzwertes Hvo ausgewertet und entsprechende Schalthandlungen ausgeführt. Auch wenn bei der durch das Schaltersignal angekündigten Schaltung des betreffenden Schalters kein Schaltlichtbogen auftritt, wird der für das Schaltsignal gespeicherte Wert im Auswertegerät 15 am Ende des Meßzeitraums von 250 Millisekunden jedenfalls gelöscht und das Auswertegerät in seinen Ausgangsschaltzustand versetzt, auch wenn das Schalten des Schalters stromlos oder lichtbogenlos erfolgte.

## Patentansprüche

1. Verfahren zur Erfassung eines Störlichtbogens in einer elektrischen Einrichtung, insbesondere in einer Mittelspannungsschaltanlage, wobei während eines begrenzten Meßzeitraumes von einem Lichtsensor bei einer relevanten Änderung der Beleuchtungsstärke ein beleuchtungsstärkeabhängiges Lichtsteuersignal generiert wird, mittels welchem beim Überschreiten wenigstens eines Grenzwertes eine Abschaltung der Energiezufuhr zur elektrischen Einrichtung gesteuert wird, **dadurch gekennzeichnet**, daß vom absolut gemessenen Beleuchtungsstärkewert ein vorgegebener Beleuchtungsstärkeschwellwert subtrahiert wird, daß bei einem absoluten Beleuchtungsstärkewert, der größer als der Beleuchtungsstärkeschwellwert ist, der Beleuchtungsstärkedifferenzwert während eines ersten Teilmeßzeitraumes in mehreren Schritten zu einem jeweils aktuellen augenblicklichen relativen Belichtungs-Istwert integriert wird, daß der jeweilige relative Belichtungs-Istwert mit einem ersten vorgegebenen Belichtungsgrenzwert verglichen wird, daß bei einem Anstieg des jeweiligen Belichtungs-Istwertes über den ersten Belichtungsgrenzwert hinaus die zeitliche Integration des Beleuchtungsstärkesignals in mehreren Schritten fortgeführt wird, daß der daraus gewonnene jeweilige Belichtungs-Iswert mit einem zweiten vorgegebenen Belichtungsgrenzwert, der höher als der erste Belichtungsgrenzwert ist, verglichen wird und daß bei einem Anstieg des jeweiligen relativen Belichtungs-Istwertes über den zweiten Belichtungsgrenzwert hinaus ein Absteuersignal generiert wird, durch welches die Abschaltung der Energiezufuhr zur elektrischen Einrichtung zumindest mittelbar eingeleitet wird.

2. Verfahren nach Anspruch 1, **dadurch gekennzeichnet**, daß das Absteuersignal mit einem von der Höhe der der elektrischen Einrichtung zugeführten Energie abgeleiteten Überstromsignal in einer logischen UND-Verknüpfung verkoppelt ist derart, daß nur bei Vorhandensein beider Signale die Abschaltung der Einrichtung eingeleitet wird.

3. Verfahren nach Anspruch 1 oder 2, **dadurch gekennzeichnet**, daß bei einem relativen Belichtungs-Istwert am Ende des ersten Teilmeßzeitraumes, der niedriger als der erste Belichtungsgrenzwert ist, die Integration abgebrochen, der aktuelle Belichtungs-Istwert gelöscht und der Beleuchtungsstärkeschwellenwert erhöht wird.

4. Verfahren nach Anspruch 1 oder einem der Folgenden, **dadurch gekennzeichnet**, daß bei einem Anstieg des relativen Belichtungs-Istwertes, der innerhalb des ersten Teilmeßzeitraums den ersten Belichtungsgrenzwert überschreitet und innerhalb des gesamten Meßzeitraums unter dem zweiten Belichtungsgrenzwert liegt, der Belichtungs-Istwert gelöscht und der Beleuchtungsstärkeschwellwert erhöht wird.

5. Verfahren nach Anspruch 1 oder einem der Folgenden, **dadurch gekennzeichnet**, daß bei einem Anstieg des relativen Belichtungs-Istwertes über den zweiten Belichtungsgrenzwert hinaus die Integration abgebrochen und der aktuelle Belichtung-Istwert gelöscht wird.

6. Verfahren nach Anspruch 3 oder einem der Folgenden, **dadurch gekennzeichnet**, daß der Beleuchtungsstärkeschwellenwert um den Quotienten aus dem zugehörigen doppelten Belichtungs-Istwert und der Dauer des ersten Teilmeßzeitraums, vorzugsweise maximal bis auf 120 Kilo-Lux angehoben wird.

7. Verfahren nach Anspruch 1 oder einem der Folgenden, **dadurch gekennzeichnet**, daß der erste Belichtungsgrenzwert bei ansteigendem Beleuchtungsstärkeschwellenwert erhöht wird.

8. Verfahren nach Anspruch 7, **dadurch gekennzeichnet**, daß der erste Belichtungsgrenzwert auf einen Wert von 20 Lux mal Sekunden plus den Wert des Produkts aus erhöhtem absolutem Beleuchtungsstärkeschwellenwert und einer halben Millisekunde gesteuert wird.

9. Verfahren nach Anspruch 1 oder einem der Folgenden, **dadurch gekennzeichnet**, daß der erste Belichtungsgrenzwert bei abnehmendem absoluten Beleuchtungsstärkeschwellwert nach einer Filterfunktion vermindert wird.

10. Lichtbogenwächter zur Durchführung des Verfahrens nach Anspruch 1 oder einem der Folgenden, **dadurch gekennzeichnet**, daß ein optoelektronischer Meßwertwandler (14) von einem optischen Sensor (8) erfaßte Lichtsignale fortlaufend in entsprechende elektrische absolute Beleuchtungsstärkewerte umsetzt und diese einem Auswertegerät (15) zuliefert, daß das Auswertegerät (15) einen Belichtungsstärkeschwellwertspeicher aufweist, in dem ein über einen längeren Zeitraum konstant bleibender Beleuchtungsstärkeschwellenwert abgelegt ist, daß aus dem absoluten Beleuchtungsstärkewert und dem Beleuchtungsstärkeschwellenwert fortlaufend in einem Vergleicher ein Differenzwert gebildet wird, daß der Vergleicher bei einem Anstieg des Beleuchtungsstärkewertes über den Beleuchtungsstärkeschwellenwert mittels eines Startsignals einen Integrator startet, der den Differenzwert aus beiden Werten jeweils zu einem augenblicklich aktuellen relativen Belichtungs-Istwert über einen ersten Teilmeßzeitraum hinweg zeitabhängig integriert, daß der jeweilige zeitabhängige Belichtungs-Istwert in einem Vergleicher mit einem vorgegebenen ersten Belichtungsgrenzwert verglichen wird, daß dieser Vergleicher bei einem Anstieg des Belichtungs-Istwertes über den ersten Belichtungsgrenzwert ein Steuersignal generiert, das die Funktion des Integrators über den ersten Teilmeßzeitraum hinaus bis höchstens zum Ende des begrenzten Meßzeitraums aufrechterhält, daß der jeweilige zeitabhängige Belichtungs-Istwert in einem Vergleicher mit einem zweiten höheren Belichtungsgrenzwert verglichen wird und daß dieser Vergleicher bei einem Anstieg des Belichtungs-Istwertes über den zweiten Belichtungsgrenzwert ein Absteuersignal generiert, welches eine Schalteinrichtung der überwachten elektrischen Einrichtung anregt.

11. Lichtbogenwächter nach Anspruch 10, **dadurch gekennzeichnet**, daß der Ausgang des das Absteuersignal generierenden Vergleichers an einen Eingang einer logischer UND-Schaltung geschaltet ist, deren zweiter Eingang an den Ausgang eines Überstromsensors angeschlossen ist, der den elektrischen Strom in der überwachten Einrichtung erfaßt und daß bei Anliegen beider Eingangssignale das Ausgangssignal der UND-Schaltung die Abschaltung der überwachten elektrischen Einrichtung steuert.

12. Lichtbogenwächter nach Anspruch 10 oder 11, **dadurch gekennzeichnet**, daß der Vergleicher, der den Belichtungsistwert im ersten Teilmeßzeitraum mit dem ersten Belichtungsgrenzwert vergleicht, bei Nichterreichen des ersten Belichtungsgrenzwertes ein Befehlssignal generiert, das eine Erhöhung des im Beleuchtungsstärkeschwellwertspeicher abgelegten Beleuchtungsstärkeschwellwertes, eine Abschaltung der Integrationseinrichtung und die Löschung des aktuellen Belichtungs-Istwertes steuert.

13. Lichtbogenwächter nach Anspruch 10 oder einem der Folgenden, **dadurch gekennzeichnet**, daß der Vergleicher, der den Belichtungs-Istwert im Meßzeitraum mit dem zweiten Belichtungsgrenzwert vergleicht, bei Nichterreichen des zweiten Belichtungsgrenzwertes ein Befehlssignal generiert, das eine Erhöhung des im Beleuchtungsstärkeschwellwertspeicher abglegten Beleuchtungsstärkeschwellwertes, eine Abschaltung des Integrators und die Löschung des aktuell integrierten Belichtungs-Istwertes in einem Belichtungsgrenzwertspeicher steuert.

14. Lichtbogenwächter nach Anspruch 10 oder einem der Folgenden, **dadurch gekennzeichnet**, daß der Vergleicher, der den Belichtungs-Istwert im Meßzeitraum mit einem zweiten Belichtungsgrenzwert vergleicht, bei Überschreiben des zweiten Belichtungsgrenzwertes ein Befehlssignal generiert, das die Schaltung des Integrators und die Löschung des aktuellen Belichtungs-Istwertes im BelichtungsIstwertespeicher steuert.

15. Lichtbogenwächter nach Anspruch 12 oder einem der folgenden, **dadurch gekennzeichnet**, daß mit der Erhöhung des Beleuchtungsstärkeschwellwertes im Beleuchtungsstärkeschwellwertspeicher eine angepaßte Erhöhung des ersten Belichtungsgrenzwertes in einem Belichtungsgrenzwertspeicher des Auswertegerätes (15) gesteuert wird.

16. Lichtbogenwächter nach Anspruch 10 oder einem der folgenden, dadurch gekennnzeichnet, daß in der überwachten Schalteinrichtung ein Lasttrennschalter in einen zu schaltenden Stromweg geschaltet ist, daß dem Lasttrennschalter ein Hilfskontakt zugeordnet ist, der bei Ausschaltungen und/oder Einschaltungen kurzzeitig schließt und an einen Schaltsignalspeicher ein Schaltsignal liefert, das verknüpft mit einem aus einem Anstieg der Beleuchtungsstärke abgeleiteten Signal den Beleuchtungsstärk-Istwert innerhalb des Meßzeitraumes für einen den ersten Teilmeßzeitraum überschreitenden weiteren Teilmeßzeitraum löscht.

17. Lichtbogenwächter nach Anspruch 16, dadurch gekennzichnet, daß der erste Teilmeßzeitraum etwa 5 Millisekunden und der weitere Teilmeßzeitraum bei gleichem Startzeitpunkt etwa 30 Millisekunden lang ist.

## Claims

1. A method of detecting a fault arc in an electrical apparatus, in particular in a medium-voltage switching installation, wherein during a limited measurement period upon a relevant change in the strength of lighting a light control signal which is dependent on the strength of lighting is generated by a light sensor, by means of which light control signal switching-off of the energy supply to the electrical apparatus is controlled when at least one limit value is exceeded, **characterised in that** a predetermined lighting strength threshold value is subtracted from the absolutely measured lighting strength value, that at an absolute lighting strength value which is greater than the lighting strength threshold value the lighting strength difference value is integrated during a first measurement period portion in a plurality of steps to form a respectively current instantaneous relative actual exposure value, that the respective relative actual exposure value is compared to a first predetermined exposure limit value, that upon a rise in the respective actual exposure value beyond the first exposure limit value time integration of the lighting strength signal is continued in a plurality of steps, that the respective actual exposure value obtained therefrom is compared to a second predetermined exposure limit value which is higher than the first exposure limit value, and that upon a rise in the respective relative actual exposure value beyond the second exposure limit value a shut-off signal is generated, by which switching-off of the energy supply to the electrical apparatus is at least indirectly initiated.

2. A method according to claim 1 **characterised in that** the shut-off signal is coupled in a logic AND-link to an overcurrent signal derived from the magnitude of the energy supplied to the electrical apparatus, in such a way that switching-off of the apparatus is initiated only when both signals are present.

3. A method according to claim 1 or claim 2 **characterised in that** at a relative actual exposure value at the end of the first measurement period portion, which is lower than the first exposure limit value, integration is interrupted, the current actual exposure value is erased and the lighting strength threshold value is increased.

4. A method according to claim 1 or one of the following claims **characterised in that** upon a rise in the relative actual exposure value, which within the first measurement period portion exceeds the first exposure limit value and which within the entire measurement period is below the second exposure limit value, the actual exposure value is erased and the lighting strength threshold value is increased.

5. A method according to claim 1 or one of the following claims **characterised in that** upon a rise in the relative actual exposure value beyond the second exposure limit value integration is interrupted and the current actual exposure value is erased.

6. A method according to claim 3 or one of the following claims **characterised in that** the lighting strength threshold value is raised by the quotient of the associated doubled actual exposure value and the duration of the first measurement period portion, preferably at a maximum up to 120 kilo-lux.

7. A method according to claim 1 or one of the following claims **characterised in that** the first exposure limit value is increased with a rising lighting strength threshold value.

8. A method according to claim 7 **characterised in that** the first exposure limit value is controlled to a value of 20 lux times seconds plus the value of the product of the increased absolute lighting strength threshold value and half a millisecond.

9. A method according to claim 1 or one of the following claims **characterised in that** the first exposure limit value is reduced with a decreasing absolute lighting strength threshold value in accordance with a filter function.

10. An arc monitor for carrying out the method according to claim 1 or one of the following claims, **characterised in that** an opto-electronic measurement value transducer (14) continuously converts light signals detected by an optical sensor (8) into corresponding electrical absolute lighting strength values and supplies same to an evaluation apparatus (15), that the evaluation apparatus (15) has a lighting strength threshold value store in which a lighting strength threshold value which remains constant over a prolonged period is stored, that a difference value is continuously formed in a comparator from the absolute lighting strength value and the lighting strength threshold value, that upon a rise in the lighting strength value above the lighting strength threshold value the comparator starts by means of a start signal an integrator which integrates the difference value from both values to afford a respective instantaneously current relative actual exposure value over a first measurement period portion in dependence on time, that the respective time-dependent actual exposure value is compared in a comparator to a predetermined first exposure limit value, that upon a rise in the actual exposure value above the first exposure limit value said comparator generates a control signal which maintains the function of the integrator beyond the first measurement period portion until at most the end of the limited measurement period, that the respective time-dependent actual exposure value is compared in a comparator to a second higher exposure limit value, and that upon a rise in the actual exposure value above the second exposure limit value said comparator generates a shut-off signal which activates a switching device of the monitored electrical apparatus.

11. An arc monitor according to claim 10 **characterised in that** the output of the comparator generating the shut-off signal is connected to an input of a logical AND-circuit whose second input is connected to the output of an overcurrent sensor which detects the electrical current in the monitored apparatus and that when both input signals are applied the output signal of the AND-circuit controls switching-off of the monitored electrical apparatus.

12. An arc monitor according to claim 10 or claim 11 **characterised in that** the comparator which compares the actual exposure value in the first measurement period portion to the first exposure limit value, when the first exposure limit value is not reached, generates a command signal which controls an increase in the lighting strength threshold value stored in the lighting strength threshold value store, switching-off of the integration device and erasure of the current actual exposure value.

13. An arc monitor according to claim 10 or one of the following claims **characterised in that** the comparator which compares the actual exposure value in the measurement period to the second exposure limit value, when the second exposure limit value is not reached, generates a command signal which controls an increase in the lighting strength threshold value stored in the lighting strength value store, switching-off of the integrator and erasure of the currently integrated actual exposure value in an exposure limit value store.

14. An arc monitor according to claim 10 or one of the following claims **characterised in that** the comparator which compares the actual exposure value in the measurement period to a second exposure limit value, when the second exposure limit value is exceeded, generates a command signal which controls switching of the integrator and erasure of the current actual exposure value in the actual exposure value store.

15. An arc monitor according to claim 12 or one of the following claims **characterised in that** with the increase in the lighting strength threshold value in the lighting strength threshold value store a matched increase is controlled in respect of the first exposure limit value in an exposure limit value store of the evaluation device (15).

16. An arc monitor according to claim 10 or one of the following claims **characterised in that** in the monitored switching apparatus a load-break switch is connected into a current path to be switched, that associated with the load-break switch is an auxiliary contact which briefly closes in switching-off situations and/or switching-on situations and supplies to a switching signal store a switching signal which linked with a signal derived from a rise in the lighting strength erases the actual lighting strength value within the measurement period for a further measurement period portion which exceeds the first measurement period portion.

17. An arc monitor according to claim 16 **characterised in that** the first measurement period portion is about 5 milliseconds long and the further measurement period portion with the same starting time is about 30 milliseconds long.

## Revendications

1. Procédé pour la détection d'un arc électrique de défaut dans un poste de réseau électrique, en particulier dans un poste de distribution à moyenne tension, dans lequel on génère, pendant un intervalle de temps de mesure limité, au moyen d'un détecteur de lumière, lors d'une modification significative de la densité de lumière, un signal de commande de lumière qui est fonction de la densité de la lumière et au moyen duquel on commande, lors du dépassement d'au moins une valeur limite, une déconnexion d'un apport d'énergie au poste de réseau électrique, **caractérisé en ce que** l'on soustrait, à une valeur de densité de la lumière mesurée dans l'absolu, une valeur de seuil prédéterminée de la densité de la lumière, en ce que, dans le cas d'une valeur absolue de la densité de la lumière, qui est plus grande que la valeur de seuil de la densité de la lumière, on intègre la valeur de différence de la densité de la lumière, pendant un premier intervalle partiel de temps de mesure, en plusieurs étapes, pour fournir, à chaque fois, une valeur relative effective actuelle instantanée de l'éclairement, en ce que l'on compare chaque valeur effective relative de l'éclairement à une première valeur limite prédéterminée de l'éclairement, en ce que, dans le cas d'une augmentation de la valeur effective respective de l'éclairement au dessus de la première valeur limite de l'éclairement, on continue l'intégration dans le temps du signal de la densité de la lumière en plusieurs étapes, en ce que l'on compare la valeur effective de l'éclairement que l'on obtient à une deuxième valeur limite prédéterminée de l'éclairement, qui est plus élevée que la première valeur limite de l'éclairement et en ce que, dans le cas d'une augmentation de la valeur relative effective de l'éclairement concernée au dessus de la deuxième valeur limite de l'éclairement, on génère un signal de commande de déconnexion au moyen duquel on initialise, au moins de manière indirecte, la déconnexion de l'apport d'énergie au poste de réseau électrique.

2. Procédé selon la revendication 1, **caractérisé en ce que** le signal de commande de déconnexion est couplé à un signal de surintensité dérivé de la grandeur de l'énergie fournie au poste de réseau électrique dans un circuit logique ET de telle manière que l'on n'initialise la déconnexion du poste que dans le cas de la présence des deux signaux.

3. Procédé selon la revendication 1 ou 2, **caractérisé en ce que**, dans le cas d'une valeur relative effective de l'éclairement présente à la fin du premier intervalle partiel de temps de mesure, qui est plus faible que la première valeur limite de l'éclairement, on interrompt l'intégration, on met à zéro la valeur relative effective de l'éclairement et on augmente la valeur de seuil de la densité de la lumière.

4. Procédé selon la revendication 1 ou l'une des revendications suivantes, **caractérisé en ce que**, dans le cas d'une augmentation de la valeur relative effective de l'éclairement, qui dépasse la première valeur limite d'éclairement à l'intérieur du premier intervalle partiel de temps de mesure et qui est inférieure à la deuxième valeur limite de l'éclairement pendant l'ensemble de l'intervalle de temps de mesure, on met à zéro la valeur effective de l'éclairement et on augmente la valeur de seuil de la densité de la lumière.

5. Procédé selon la revendication 1 ou l'une des revendications suivantes, **caractérisé en ce que**, dans le cas d'une augmentation de la valeur relative effective de l'éclairement au dessus de la deuxième valeur limite de l'éclairement, on interrompt l'intégration et on met à zéro la valeur effective actuelle de l'éclairement.

6. Procédé selon la revendication 3 ou l'une des revendications suivantes, **caractérisé en ce que** l'on élève la valeur de seuil de la densité de la lumière d'une valeur égale au quotient du double de la valeur effective de l'éclairement correspondante par la durée du premier intervalle partiel de temps de mesure, de préférence, au maximum, jusqu'à 120 kilolux.

7. Procédé selon la revendication 1 ou l'une des revendications suivantes, **caractérisé en ce que** la première valeur limite de l'éclairement est augmentée lorsque la valeur de seuil de la densité de la lumière augmente.

8. Procédé selon la revendication 7, **caractérisé en ce que** la première valeur limite de l'éclairement est commandée pour atteindre une valeur de 20 lux par seconde à laquelle on ajoute la valeur du produit de la valeur absolue augmentée de seuil de la densité de la lumière et d'une moitié de milliseconde.

9. Procédé selon la revendication 1 ou l'une des revendications suivantes, **caractérisé en ce que** l'on réduit, selon une fonction de filtre, la première valeur limite de l'éclairement lorsque la valeur absolue de seuil de la densité de la lumière diminue.

10. Dispositif de surveillance de l'apparition d'un arc électrique pour la mise en oeuvre du procédé selon la revendication 1 ou l'une des revendications suivantes, **caractérisé en ce qu**'un transformateur optoélectronique de valeurs de mesure (14) transforme, en continu, des signaux de lumière captés par un capteur optique (8) en valeurs électriques correspondantes absolues de la densité de la lumière et envoie ces dernières à un appareil d'évaluation (15), en ce que l'appareil d'évaluation (15) comporte une mémoire de valeurs de seuil de la densité de la lumière dans laquelle on enregistre une valeur de seuil de la densité de la lumière qui reste constante pendant un intervalle de temps plus long, en ce que l'on forme, dans un comparateur, à partir de la valeur absolue de la densité de la lumière et de la valeur de seuil de la densité de la lumière, une valeur de différence, en ce que le comparateur fait démarrer, dans le cas d'une augmentation de la valeur de la densité de la lumière au dessus de la valeur de seuil de la densité de la lumière, au moyen d'un signal de démarrage, un intégrateur qui intègre en fonction du temps la valeur de différence provenant des deux valeurs, à chaque fois, pour atteindre une valeur relative effective actuelle instantanée de l'éclairement, pendant un premier intervalle partiel de temps de mesure, en ce que l'on compare, dans un comparateur, la valeur effective respective de l'éclairement en fonction du temps à une première valeur limite de l'éclairement prédéterminée, en ce que ce comparateur génère, dans le cas d'une augmentation de la valeur effective de l'éclairement au dessus de la première valeur limite de l'éclairement, un signal de commande qui maintient le fonctionnement de l'intégrateur dans le premier intervalle partiel de temps de mesure au maximum jusqu'à la fin de l'intervalle de temps de mesure limité, en ce que l'on compare, dans un comparateur, à chaque fois, la valeur effective de l'éclairement en fonction du temps à une deuxième valeur limite de l'éclairement plus élevée et en ce que ce comparateur génère, dans le cas d'une augmentation de la valeur effective de l'éclairement au dessus de la deuxième valeur limite de l'éclairement, un signal de commande de déconnexion qui active un dispositif de commutation du poste de réseau électrique surveillé.

11. Dispositif de surveillance de l'apparition d'un arc électrique selon la revendication 10, **caractérisé en ce que** la sortie du comparateur générant le signal de commande de déconnexion est connectée à une entrée d'un circuit logique ET dont la deuxième entrée est reliée à la sortie d'un détecteur de surintensité qui mesure le courant électrique circulant dans le poste surveillé et en ce que, dans le cas de la présence des deux signaux d'entrée, le signal de sortie du circuit ET commande la déconnexion du poste de réseau électrique surveillé.

12. Dispositif de surveillance de l'apparition d'un arc électrique selon la revendication 10 ou 11, **caractérisé en ce que** le comparateur qui compare, pendant le premier intervalle partiel de temps de mesure, la valeur effective de l'éclairement à la première valeur limite de l'éclairement, génère, lorsque l'on n'atteint pas la première valeur limite de l'éclairement, un signal d'ordre qui commande une augmentation de la valeur de seuil de la densité de la lumière enregistrée dans la mémoire de valeurs de seuil de la densité de la lumière, une déconnexion du dispositif d'intégration et la mise à zéro de la valeur effective actuelle de l'éclairement.

13. Dispositif de surveillance de l'apparition d'un arc électrique selon la revendication 10 ou l'une des revendications suivantes, **caractérisé en ce que** le comparateur qui compare la valeur effective de l'éclairement pendant l'intervalle de temps de mesure à la deuxième valeur limite de l'éclairement, génère, lorsque l'on n'atteint pas la deuxième valeur limite de l'éclairement, un signal d'ordre qui commande une augmentation de la valeur de seuil de la densité de la lumière qui est enregistrée dans la mémoire de valeurs de seuil de la densité de la lumière, une déconnexion de l'intégrateur et la mise à zéro de la valeur effective actuelle intégrée de l'éclairement se trouvant dans une mémoire de valeurs limites de l'éclairement.

14. Dispositif de surveillance de l'apparition d'un arc électrique selon la revendication 10 ou l'une des revendications suivantes, **caractérisé en ce que** le comparateur qui compare la valeur effective de l'éclairement pendant l'intervalle de temps de mesure à une deuxième valeur limite de l'éclairement, génère, lorsque l'on dépasse la deuxième valeur limite de l'éclairement, un signal d'ordre qui commande la mise en service de l'intégrateur et la mise à zéro de la valeur effective actuelle de l'éclairement se trouvant dans la mémoire de valeurs effectives de l'éclairement.

15. Dispositif de surveillance de l'apparition d'un arc électrique selon la revendication 12 ou l'une des revendications suivantes, **caractérisé en ce que** l'on commande, par l'augmentation de la valeur de seuil de la densité de la lumière se trouvant la mémoire de valeurs de seuil de la densité de la lumière , une augmentation adaptée de la première valeur limite de l'éclairement se trouvant dans une mémoire de valeurs limites de l'éclairement de l'appareil d'évaluation (15).

16. Dispositif de surveillance de l'apparition d'un arc électrique selon la revendication 10 ou l'une des revendications suivantes, **caractérisé en ce que**, dans le poste de commutation surveillé, on branche un sectionneur à coupure en charge dans un trajet de courant à commuter, en ce que l'on adjoint au sectionneur à coupure en charge un contact auxiliaire qui se ferme de manière instantanée lors de déconnexions et/ou de connexions et fournit, à une mémoire de signaux de commutation, un signal de commutation qui, en combinaison avec un signal dérivé d'une augmentation de la densité de la lumière, met à zéro la valeur effective de la densité de la lumière à l'intérieur de l'intervalle de temps de mesure pour un autre intervalle partiel de temps de mesure dépassant le premier intervalle partiel de temps de mesure.

17. Dispositif de surveillance de l'apparition d'un arc électrique selon la revendication 16, **caractérisé en ce que** le premier intervalle partiel de temps de mesure a une longueur d'environ 5 millisecondes et en ce que l'autre intervalle partiel de temps de mesure a, pour le même point de départ, une longueur d'environ 30 millisecondes.
